# EUROPÄISCHE PATENTSCHRIFT

(11) **EP 2 669 582 B1**
(45) Veröffentlichungstag und Bekanntmachung des Hinweises auf die Patenterteilung: **08.07.2020**
(21) Anmeldenummer: 13168924.2
(22) Anmeldetag: 23.05.2013
(51) Int. Cl.: F24C 7/08, H03K 17/97, G05G 1/08

(54) **Haushaltsgerät mit Drehknebel und Verfahren zum Betreiben eines Haushaltsgeräts**
Domestic appliance with rotating knob and method of operating a domestic appliance
Appareil ménager avec manette rotative et procédé de fonctionnement d'un appareil ménager

(30) Priorität: 31.05.2012 DE 102012209206
(43) Veröffentlichungstag der Anmeldung: 04.12.2013
(73) Patentinhaber: BSH Hausgeräte GmbH, 81739 München (DE)
(72) Erfinder: Grützke, Joachim, 85560 Ebersberg (DE); Schmidt, Tobias, 80636 München (DE)

(56) Entgegenhaltungen:
- EP-A2- 1 901 005
- WO-A1-2006/108619
- DE-A1- 10 212 953
- DE-A1-102005 003 593
- DE-A1-102009 039 209

## Beschreibung

Die Erfindung betrifft ein Haushaltsgerät mit einem Drehknebel, das Haushaltsgerät aufweisend einen Positionierungsbereich zur abnehmbaren Positionierung eines Drehknebels, welcher Drehknebel mindestens einen magnetisch anziehbaren Körper aufweist,. Die Erfindung betrifft auch ein Verfahren zum Betreiben eines Haushaltsgeräts, welches zu seiner Bedienung mindestens einen Drehknebel mit mindestens einem magnetisch anziehbaren Körper aufweist.

DE 10 2006 034 391 A1 offenbart eine Bedienvorrichtung für ein Kochfeld mit einem Bedienknebel mit wenigstens einem zumindest magnetisierbaren Element zum Positionieren des Bedienknebels an einer definierten Position des Kochfelds durch eine Magnetkraft, mit einer sich in einer Standebene erstreckenden Standflache zum Abstützen auf dem Kochfeld in einer Ruheposition. Ferner wird vorgeschlagen, dass die Bedienvorrichtung eine die Standfläche umgebende Auflagefläche zum Abstützen des Bedienknebels in einer Kippposition umfasst, wobei die Auflagefläche in der Ruheposition der Standebene der Standfläche zugewandt ist. Umfasst der Bedienknebel eine Mehrzahl von gleichmäßig um eine senkrecht zur Standfläche verlaufende Rotationsachse verteilten Magneten, kann eine Rotationsbewegung des Bedienknebels einfach mit Hilfe von Hallsensoren oder geeigneten induktiven Sensoren erkannt werden. Ferner wird offenbart ein Kochfeld mit einer Detektorvorrichtung zum Detektieren einer Drehlage und/oder Drehbewegung eines durch eine Magnetkraft in einer vorgegebenen Position gehaltenen Bedienknebels, bezogen auf eine senkrecht zu einer Standebene des Bedienknebels verlaufende Rotationsachse. Hierbei ist es nachteilig, dass der Bedienknebel keine oder keine signifikante haptische Rückmeldung bewirkt.

WO 2006/108619 A1 offenbart eine Bedienvorrichtung für ein Elektrowärmegerät, welches ein Bedienelement aufweist, das drehbar und abnehmbar auf einer Halterfläche mittels einer Haltekraft aufliegt. Das Bedienelement weist zur Halterfläche hin eine Bedienelement-Unterseite auf und die Halterfläche zum Bedienelement hin eine ebene Halterflächen-Oberseite auf. Die Bedienelement-Unterseite ist in einem ersten Flächenbereich für eine stabile Lage des Bedienelements in einer stabilen Grundposition flach ausgebildet, was durch die Haltekraft unterstützt wird. Dieser erste Flächenbereich ist von einem anschließenden zweiten Flächenbereich umgeben, der eine zurückweichende Wölbung aufweist derart, dass das Bedienelement aus der Grundposition bei bleibendem Kontakt zur Halterfläche kippbar ist. Es sind Erkennungsmittel zum Erkennen der Position des Bedienelements in der Grundposition oder einer anderen Position und zur Auslösung einer Bedienfunktion vorgesehen.

DE 10 2005 003 593 A1 offenbart ein Bedienelement für ein Kraftfahrzeug mit einem Gehäuse und einem Drehknopf und einer an dem Drehknopf angeordneten Drehachse und einem an der Drehscheibe angreifenden Bremselement, mittels der ein veränderbares Bremsmoment an den Drehknopf übertragbar ist, wobei zwischen dem Drehknopf und dem Bremselement ein eine Federwirkung erzielendes Element eingebracht ist, so dass eine Relativbewegung zwischen Drehknopf und Bremselement realisierbar ist.

Es ist die **Aufgabe** der vorliegenden Erfindung, die Nachteile des Standes der Technik zumindest teilweise zu überwinden und insbesondere eine Möglichkeit zur haptischen Rückmeldung an einen Nutzer zu geben, der den Drehknebel zum Bedienung des Haushaltsgeräts benutzt.

Diese Aufgabe wird gemäß den Merkmalen der unabhängigen Ansprüche gelöst. Bevorzugte Ausführungsformen sind insbesondere den abhängigen Ansprüchen entnehmbar.

Die Aufgabe wird gelöst durch ein Haushaltsgerät, aufweisend einen Positionierungsbereich zur abnehmbaren Positionierung bzw. Befestigung eines Drehknebels, welcher Drehknebel mindestens einen magnetisch anziehbaren Körper aufweist,. Der Drehknebel ist also an dem Bedienfeld (lösbar) aufsetzbar und kann folglich dazu vorgesehen sein, von einem Nutzer von dem Positionierungsbereich abgenommen zu werden, z.B. zur verbesserten Reinigung des Haushaltsgeräts und/oder für eine verbesserte Kindersicherung. Ein solches Haushaltsgerät und/oder ein zugehöriger Drehknebel können z.B. ähnlich zu DE 10 2006 034 391 A1 ausgestaltet sein. Das Haushaltsgerät weist ferner mindestens eine steuerbare Magnetfeldvorrichtung zur Bereitstellung eines (insbesondere anziehenden) Magnetfelds am Ort zumindest eines Teils der gleichmäßig um die Rotationsachse (R) verteilten magnetisch anziehbaren Körper des Drehknebels zur Änderung eines Drehwiderstands einer Drehbewegung des Drehknebels auf. Folglich kann der Drehwiderstand gezielt variiert werden, was ein Nutzer als haptische Rückbildung wahrnimmt. Dadurch können auch bisher bekannte Drehknebel mit einer haptischen Rückmeldung versehen werden.

Die abnehmbare Positionierung bzw. Befestigung des Drehknebels kann insbesondere eine magnetische Positionierung bzw. Befestigung sein. Jedoch sind das Haushaltsgerät und der Drehknebel nicht darauf beschränkt, und der Drehknebel kann z.B. auch durch sein Gewicht abnehmbar positioniert sein.

Der mindestens eine magnetisch anziehbare Körper kann einen solchen Körper oder mehrere solche Körper aufweisen. Der mindestens eine magnetisch anziehbare Körper kann insbesondere mindestens einen (permanent-)magnetischen Körper (Magneten) und/oder mindestens einen magnetisierbaren Körper aufweisen. Unter einem magnetisierbaren Körper kann insbesondere ein Körper verstanden werden, welcher selbst nicht oder nur vernachlässigbar gering magnetisch ist, aber durch das Magnetfeld anziehbar ist, z.B. ein eisen-, kobalt- und/oder nickelhaltiger Körper. Die Verwendung eines magnetischen Körpers ermöglicht eine besonders starke Anziehungskraft. Die Verwendung mindestens eines magnetisierbaren Körpers ermöglicht eine besonders geringe Beeinflussung einer Detektion einer Drehstellung und/oder Drehrichtung des Drehknebels.

Falls der Drehknebel mehrere magnetisch anziehbare Körper aufweist, können insbesondere alle diese Körper als magnetische Körper bzw. als (Permanent-)Magnete ausgebildet sein. Erfindungsgemäß weist der mindestens eine magnetisch anziehbare Körper mehrere magnetisch anziehbare Körper auf, von denen mehrere Körper gleichmäßig um seine Rotationsachse verteilt sind. Zumindest einige der Körper können als Magnete ausgebildet sein. Alternativ oder zusätzlich können von mehreren magnetisch anziehbaren Körpern mehrere Körper auch als magnetisierbare Körper ausgebildet und gleichmäßig um die Rotationsachse verteilt sein. Dies ermöglicht erstens eine aufgrund einer hohen Hebelwirkung eines besonders effektive Abbremsung und zweitens eine Bereitstellung eines Drehknebels mit einer magnetisch detektierbaren Drehstellung und/oder Drehrichtung.

Alternativ mag der Drehknebel beispielsweise einen zentralen Magneten aufweisen, welcher selbst mehrere nach außen, insbesondere radial nach außen, gerichtete Bereiche (z.B. "Arme") aufweist oder welcher mit einem magnetisierbaren Körper mit nach außen gerichteten Bereichen magnetisch gekoppelt, z.B. verbunden, ist. Der zentrale Magnet mag auch zur magnetischen Befestigung an dem Positionierungsbereich dienen.
Jedoch sind das Haushaltsgerät und der Drehknebel nicht darauf beschränkt und können z.B. eine Drehstellung und/oder Drehrichtung auch anders detektieren z.B. optisch.

Jedoch sind das Haushaltsgerät und/oder der Drehknebel nicht darauf begrenzt, dass das von der Magnetfeldvorrichtung erzeugte Magnetfeld zur Erzeugung der haptischen Rückmeldung auf die zur Erkennung einer Drehung vorgesehenen magnetisch anziehbaren Körper, insbesondere Magnete, des Drehknebels wirkt. So mag der Drehknebel zusätzlich mindestens einen weiteren magnetisch anziehbaren Körper, insbesondere Magneten, aufweisen, der dediziert oder ausschließlich zur Wechselwirkung mit der Magnetfeldvorrichtung vorgesehen ist. Dadurch mag ein Aufbau erleichtert werden und/oder es mag eine Beeinflussung einer Feststellung einer Drehung oder Drehstellung durch das von der Magnetfeldvorrichtung erzeugte Magnetfeld verringert werden.

Beispielsweise mag der Drehknebel einen kreisförmigen, insbesondere konzentrisch zu der Rotationsachse angeordneten, magnetisch anziehbare Körper, insbesondere Magneten, aufweisen. Dieser mag insbesondere in einer bezüglich der Rotationsachse radialen Richtung zwischen einem mittigen Befestigungsmagneten und den zur Feststellung der Drehstellung und/oder Drehbewegung verwendeten magnetisch anziehbaren Körper, insbesondere Magneten, angeordnet sein. Alternativ mögen konzentrisch und gleichmäßig um die Rotationsachse angeordnete mehrere magnetisch anziehbare Körper, insbesondere Magnete, verwendet werden. Dieser dedizierte Körper oder die mehreren dedizierten Körper können auch in radialer Richtung außerhalb der zur Feststellung der Drehstellung und/oder Drehbewegung verwendeten magnetisch anziehbaren Körper, insbesondere Magnete, angeordnet sein. Die Aufgabe wird auch mittels eines solchen Drehknebels gelöst. Erfindungsgemäß weist die Magnetfeldvorrichtung mindestens einen Elektromagneten zur Erzeugung des Magnetfelds auf. Dies ermöglicht eine besonders einfach aufgebaute Magnetfeldvorrichtung, mittels derer das Magnetfeld und damit der Drehwiderstand besonders effektiv und genau einstellbar ist. Alternativ mag die Magnetfeldvorrichtung z.B. mindestens einen Permanentmagneten aufweisen, dessen Abstand zu dem Drehknebel einstellbar ist, z.B. motorisch oder aktorisch. In noch einer Alternative mag eine Abschirmung zwischen dem mindestens einen magnetisch anziehbaren Körper, insbesondere Magneten, des Drehknebels und mindestens einem Permanentmagneten des Haushaltsgeräts verschoben werden.

Es ist eine Weiterbildung, dass das von der Magnetfeldvorrichtung erzeugte Magnetfeld anziehend ist und den Drehknebel bzw. zumindest eines Teils seiner magnetisch anziehbaren Körper, insbesondere Magnete, in Richtung des Bedienfelds zieht. Folglich erhöhen sich die Andrückkraft des Drehknebels an dem Positionierungsbereich und dadurch der Drehwiderstand.

Es ist noch eine Ausgestaltung, dass die mindestens eine steuerbare Magnetfeldvorrichtung dazu eingerichtet ist, ein zumindest im Wesentlichen gleichmäßig(es) anziehendes Magnetfeld im Bereich einer Bahn zumindest eines Teils des mindestens einen magnetisch anziehbaren Körpers, insbesondere Magneten, zu erzeugen. Dadurch kann eine asymmetrische Kraftausübung auf den mindestens einen magnetisch anziehbaren Körper des Drehknebels vermieden werden. So kann insbesondere eine Erzeugung einer nicht nutzererzeugten Kippbewegung vermieden werden. Auch kann so vermieden werden, dass auf den Drehknebel eine Drehkraft um seine Rotationsachse ausgeübt wird.

Es ist eine weitere Ausgestaltung, dass die mindestens eine steuerbare Magnetfeldvorrichtung dazu eingerichtet ist, ein lokal anziehendes Magnetfeld im Bereich einer Bahn mindestens eines Teils des mindestens einen magnetisch anziehbaren Körpers, insbesondere Magneten, zu erzeugen, wobei lokal anziehende Bereiche einen Abstand (insbesondere einer Bogenlänge) aufweisen, welcher einem Abstand des mindestens einen magnetisch anziehbaren Körpers (separater Körper oder z.B. auch unterschiedlicher Arme eines Körpers) entspricht. Es kann also ein Magnetfeld erzeugt werden, dessen anziehende Bereiche oder besonders stark anziehende Bereiche ähnlich einer Anordnung des mindestens einen magnetisch anziehbaren Körpers des Drehknebels angeordnet sind. Dadurch lässt sich eine sich rastend anfühlende Haptik mit feinem Raster bereitstellen.

Es ist auch eine Weiterbildung, dass die mindestens eine steuerbare Magnetfeldvorrichtung dazu eingerichtet ist, ein lokal anziehendes Magnetfeld in einem Bereich einer Bahn zumindest eines Teils des mindestens einen magnetisch anziehbaren Körpers, insbesondere Magneten, zu erzeugen, wobei lokal anziehende Bereiche einen Abstand aufweisen, welcher einem vielfachen Abstand dieses mindestens einen Körpers (separater Körper oder z.B. auch unterschiedlicher Arme eines Körpers) entspricht. Dadurch lässt sich beispielsweise eine sich rastend anfühlende Haptik mit einem gröberen Raster bereitstellen.

Es ist eine weitere Ausgestaltung, dass die mindestens eine steuerbare Magnetfeldvorrichtung dazu eingerichtet ist, das Magnetfeld symmetrisch sektorförmig zu der Rotationsachse im Bereich der Bahn zumindest eines Teils des mindestens einen magnetisch anziehbaren Körpers, insbesondere Magneten, zu erzeugen. Dadurch mag eine noch einfachere Magnetfeldvorrichtung bereitgestellt werden. Auch die symmetrisch sektorförmige Erzeugung verhindert eine unerwünschte Kippung des Drehknebels.

Es ist auch eine Ausgestaltung, dass die mindestens eine steuerbare Magnetfeldvorrichtung dazu eingerichtet ist, das Magnetfeld vollständig umlaufend im Bereich der Bahn zumindest eines Teils des mindestens einen magnetisch anziehbaren Körpers, insbesondere Magneten, zu erzeugen. Dies ermöglicht eine gleichmäßige Kraftausübung auf den Drehknebel über die Länge der Laufbahn der Körper des Drehknebels, und zwar ohne ein Kippmoment senkrecht zur Rotationsachse.

Es ist außerdem eine Ausgestaltung, dass das Haushaltsgerät ein Kochgerät mit einer oberseitigen Kochfeldplatte ist und dass die mindestens eine steuerbare Magnetfeldvorrichtung unterhalb der Kochfeldplatte angeordnet ist. Dadurch kann die Magnetfeldvorrichtung nahe an den (oberseitigen) Positionierungsbereich der Kochfeldplatte herangeführt werden. Die Kochfeldplatte mag insbesondere eine glasartige Kochfeldplatte sein und mag z.B. aus Hartglas oder Glaskeramik bestehen. Gemäß der vorliegenden Erfindung ist das Haushaltsgerät dazu eingerichtet, eine Stärke des Magnetfelds in Abhängigkeit von mindestens einem durch den Drehknebel einstellbaren Betriebsparameter einzustellen. So lässt sich eine haptische Rückmeldung an den mindestens einen Betriebsparameter anpassen, was eine besonders angenehme und/oder ergonomisch günstige Bedienung ermöglicht.

Es ist eine Ausgestaltung davon, dass der mindestens eine Betriebsparameter eine Kochstufe umfasst. Dies ermöglicht eine haptische Rückmeldung in Bezug auf die häufig mit einem Drehknebel verbundene Funktion der Auswahl einer Kochstufe durch Drehung des Drehknebels. Beispielsweise mag eine Kochstufe durch Drehung des Drehknebels im Uhrzeigersinn zwischen einem Wert "0" (aus) und einem Wert "9" (maximale Kochstufe) hochgestellt werden, ggf. in Halbschritten. Analog mag die Kochstufe durch Drehung des Drehknebels gegen den Uhrzeigersinn zwischen "9" und "0" heruntergestellt werden, ggf. in Halbschritten.

Es ist noch eine Ausgestaltung, dass das Haushaltsgerät dazu eingerichtet ist, die eine Stärke des Magnetfelds so einzustellen, dass mit einem Erreichen eines Endwerts eines aktuell einstellbaren Betriebsparameters ein (virtueller) Endanschlag bereitgestellt wird. Mit dem Endanschlag kann insbesondere ein fühlbar höherer Drehwiderstand verbunden sein als mit anderen Werten dieses Betriebsparameters. So können die Vorteile eines abnehmbaren Drehknebels mit dem Vorteil einer Bereitstellung eines Endanschlags eines nicht abnehmbaren Drehknebels vereint werden. Insbesondere mag der Drehknebel weiter beliebig ausgerichtet auf dem Bedienfeld aufgesetzt werden. Die Stärke des Magnetfelds ist also insbesondere nicht von einer Ausrichtung des Drehelements abhängig.

Es ist eine Weiterbildung, dass die Magnetfeldvorrichtung dazu eingerichtet ist, für den Drehknebel einen 'virtuellen' Endanschlag im Uhrzeigersinn bei Erreichen einer maximalen Kochstufe und/oder einen 'virtuellen' Endanschlag gegen den Uhrzeigersinn bei Erreichen einer minimalen Kochstufe, z.B. "0", bereitzustellen

Es ist noch eine Ausgestaltung, dass das Haushaltsgerät dazu eingerichtet ist, die Stärke des Magnetfelds so einzustellen, dass mit einer Näherung an einen Endwert eines aktuell einstellbaren Betriebsparameters eine steigende Stärke des Magnetfelds bereitgestellt wird. So kann beispielsweise mit steigendem/sinkendem Wert eines Betriebsparameters der Drehwiderstand stetig erhöht werden, z.B. linear, und insbesondere mit sinkendem/steigenden Wert wieder entsprechend erniedrigt werden. Dadurch kann z.B. ein an eine Feder angelenkter Drehknebel haptisch simuliert werden.

Die Aufgabe wird auch gelöst durch ein System aus einem solchen Haushaltsgerät und mindestens einem wie oben beschriebenen Drehknebel.

Der Drehknebel kann insbesondere eine Mehrzahl von gleichmäßig um seine Rotationsachse verteilten Magneten aufweisen.

Die Aufgabe wird auch durch ein Verfahren zum Betreiben eines Haushaltsgeräts gelöst. Das Verfahren weist unter anderem zu seiner Bedienung mindestens einen abnehmbar befestigbaren Drehknebel wie oben beschrieben (mit mindestens einem magnetisch anziehbaren Körper, insbesondere mit einer Mehrzahl von gleichmäßig um seine Rotationsachse verteilten Magneten) auf, wobei das Verfahren mindestens den folgenden Schritt aufweist: Bereitstellen eines Magnetfelds am Ort zumindest eines magnetisch anziehbaren Körper des Drehknebels, um einen Drehwiderstand einer Drehbewegung des Drehknebels zu ändern. Das Verfahren kann ähnlich zu dem Haushaltsgerät und/oder zu dem System ausgestaltet werden und ergibt die gleichen Vorteile. Insbesondere dient das Verfahren dazu, einen Drehwiderstand einer Drehbewegung des Drehknebels zu ändern. Des Weiteren wird eine Stärke des Magnetfelds in Abhängigkeit von mindestens einem durch den Drehknebel einstellbaren Betriebsparameter eingestellt.

In den folgenden Figuren wird die Erfindung anhand von Ausführungsbeispielen schematisch genauer beschrieben. Dabei können zur Übersichtlichkeit gleiche oder gleichwirkende Elemente mit gleichen Bezugszeichen versehen sein.
- Fig.1: zeigt in Draufsicht ein System aus einem Haushaltsgerät und einem Drehknebel gemäß einem ersten Ausführungsbeispiel;
- Fig.2: zeigt das System gemäß dem ersten Ausführungsbeispiel als Schnittdarstellung in Seitenansicht; und
- Fig.3: zeigt als Schnittdarstellung in Seitenansicht ein System aus einem Haushaltsgerät und einem Drehknebel gemäß einem zweiten Ausführungsbeispiel.

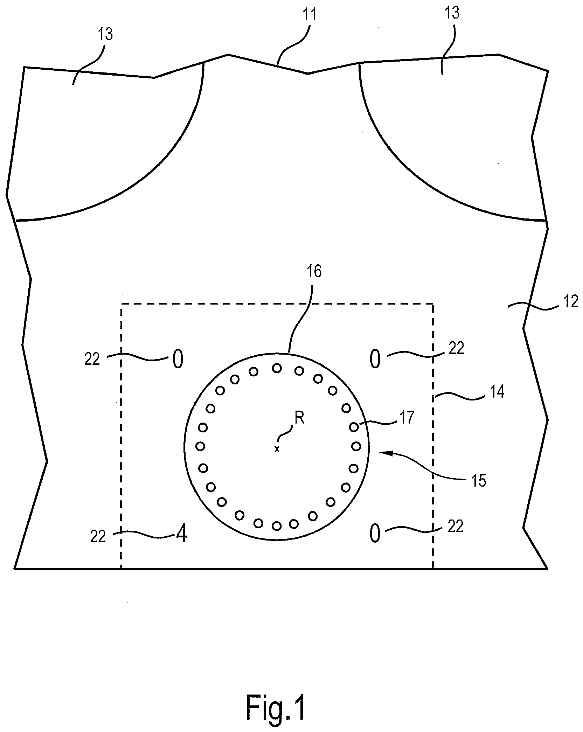

**Fig.1** zeigt ein Haushaltsgerät in Form eines Kochgeräts 11 mit einer oberseitigen Kochplatte 12 aus Hartglas oder Glaskeramik. Das Kochgerät 11 weist mehrere Kochstellen 13 als auch ein Bedienfeld 14 auf. Das Bedienfeld 14 weist oberseitig einen Positionierungsbereich 15 zur magnetischen Positionierung oder Aufsatz eines Drehstellers oder Drehknebels 16 auf. Das Bedienfeld weist ferner mehrere Anzeigefelder 22 auf, z.B. zum Anzeigen einer Kochstufe einer jeweiligen Kochstelle 13, wobei das einer links unten angeordneten Kochstelle 13 zugehörige linke untere Anzeigefeld 22 eine Kochstufe "4" anzeigt und ansonsten ausgeschaltete Kochstellen 13 anzeigt, die einen Wert "0" anzeigen. Beispielsweise mag eine aktuelle Kochstufe durch Drehung des Drehknebels 16 in Draufsicht im Uhrzeigersinn zwischen einem Wert "0" (aus) und einem Wert "9" (maximale Kochstufe) hochgestellt werden, ggf. in Halbschritten. Analog mag die Kochstufe durch Drehung des Drehknebels 16 gegen den Uhrzeigersinn zwischen "9" und "0" heruntergestellt werden, ggf. in Halbschritten.

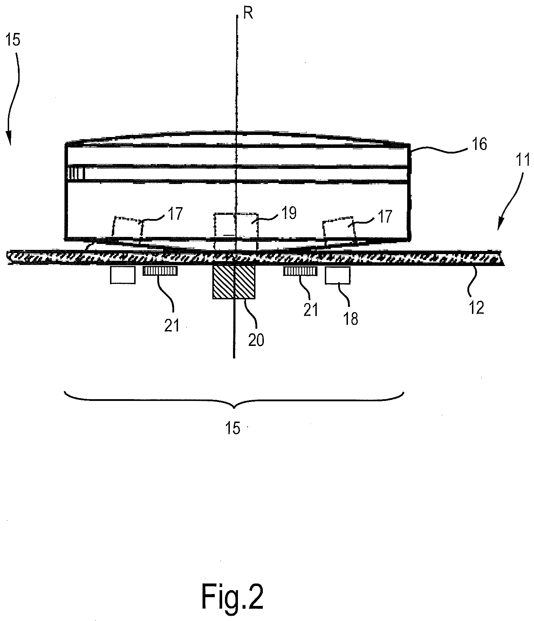

Der Drehknebel 16 weist mehrere magnetisch anziehbare Körper in Form von (Permanent-)Magneten 17 auf, welche gleichmäßig ringförmig um seine Rotationsachse R verteilt sind. Zur Feststellung einer Drehbewegung und/oder Drehstellung ist unterhalb der Kochfeldplatte 12 und der Magnete 17 eine Detektionseinheit mit mehreren Hallsensoren 18 angebracht, wie in **Fig.2** gezeigt, die eine Annäherung und Entfernung der Magnete 17 feststellen kann bzw. können. Der Drehknebel 16 weist zudem einen mittigen permanenten Befestigungsmagneten 19 auf, welcher zur Befestigung und radialen Ausrichtung des Drehknebels 16 auf dem Positionierungsbereich 15 dient. Das Kochgerät 11 weist unterhalb der Kochfeldplatte 12 einen entsprechenden, mittig zu der gewünschten Rotationsachse R angeordneten Magneten 20 auf, der ein Permanentmagnet oder ein Elektromagnet sein kann. Die Magneten 19 und 20 ziehen sich insbesondere mit einer konstanten Kraft an. Eine grundsätzliche Arbeitsweise eines solchen Drehknebels 16 ist bereits aus DE 10 2006 034 391 A1 bekannt und braucht hier nicht weiter ausgeführt zu werden.

Das Kochgerät 11 weist ferner mindestens eine unterhalb der Kochfeldplatte 12 angeordnete steuerbare Magnetfeld(erzeugungs)vorrichtung 21 zur Bereitstellung eines in Richtung der Kochfeldplatte 12 anziehenden Magnetfelds am Ort der Magnete 17 des Drehknebels 16 auf. Durch ein Aktivieren der Magnetfeldvorrichtung 21 und damit ein Einschalten des Magnetfelds kann eine Drehbewegung der Magnete 17 um die Rotationsachse R abgebremst werden und auch der Drehknebel 16 stärker auf die Kochfeldplatte 12 gedrückt werden, was einen Drehwiderstand erhöht und ein Nutzer als haptische Rückbildung wahrnimmt. Die haptische Rückmeldung kann insbesondere auch durch eine kontinuierliche oder stufenweise Änderung der Stärke des Magnetfelds erreicht werden. Die Magnetfeldvorrichtung 21 ist hier als ein ringförmiger, konzentrisch zu der Rotationsachse R angeordneter Elektromagnet ausgebildet.

Alternativ zu dem einen ringförmigen Elektromagneten kann die Magnetfeldvorrichtung 21 beispielsweise auch mehrere konzentrisch und gleichmäßig um die Rotationsachse R angeordnete Magnete verwendet werden, Diese können beispielsweise in Lücken zwischen den Hallsensoren 18 angeordnet sein, was eine besonders starke Anziehung der Magnete 17 ermöglicht. Dadurch wird eine im Bereich der Bahn der Magnete 17 vollständig umlaufend, symmetrische Kraftausübung auf die Magnete 17 des Drehknebels 16 erreicht. Insbesondere eine Erzeugung einer nicht nutzererzeugten Kippbewegung kann so vermieden werden.

Das Kochgerät 11 ist (z.B. mittels einer nicht gezeigten Steuereinrichtung) ferner dazu eingerichtet, eine Stärke des von der Magnetfeldvorrichtung 21 erzeugten Magnetfelds in Abhängigkeit von mindestens einem durch den Drehknebel 16 einstellbaren Betriebsparameter einzustellen, z.B. von der Kochstufe. So lässt sich eine haptische Rückmeldung an den Wert der Kochstufe anpassen. Insbesondere mag das Kochgerät 11 dazu eingerichtet sein, die eine Stärke des Magnetfelds so einzustellen, dass mit einem Erreichen eines Endwerts der Kochstufe ein (virtueller) Endanschlag bereitgestellt wird. Beispielsweise kann die Magnetfeldvorrichtung 21 dazu eingerichtet sein, für den Drehknebel 16 einen 'virtuellen' Endanschlag im Uhrzeigersinn bei Erreichen einer maximalen Kochstufe und/oder einen 'virtuellen' Endanschlag gegen den Uhrzeigersinn bei Erreichen einer minimalen Kochstufe, z.B. "0", bereitzustellen, indem dann ein besonders starkes Magnetfeld erzeugt wird. Die Erzeugung des besonders starken Magnetfelds kann insbesondere auf den Fall beschränkt werden, dass eine tatsächliche oder zu erwartende Drehung des Drehknebels 16 über den Endwert vorliegt, z.B. bei einem Durchdrehenlassen des Drehknebels 16. Nach einem Stoppen des Drehknebels 16 durch den 'Endanschlag' mag die Stärke des Magnetfelds wieder verringert werden. Auch mag der Endanschlag, insbesondere mit einem vergleichsweise hohen Drehwiderstand, überdrehbar sein.

Das Kochgerät 11 und der Drehknebel 16 bilden zusammen ein System, oder es kann der Drehknebel 16 als (abnehmbarer) Teil des Kochgeräts 11 angesehen werden.

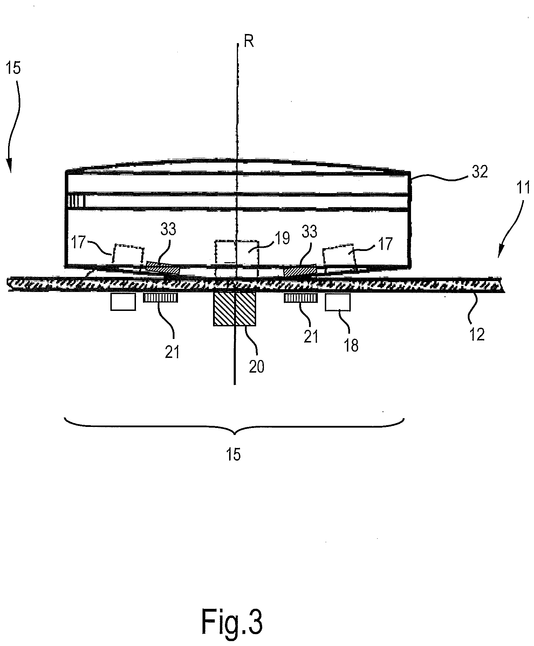

**Fig.3** zeigt als Schnittdarstellung in Seitenansicht ein System 11, 32 aus dem Kochgerät 11 und einem Drehknebel 32 gemäß einem zweiten Ausführungsbeispiel. Der Drehknebel 32 ist ähnlich zu dem Drehknebel 16 ausgebildet, weist aber direkt oberhalb der Magnetfeldvorrichtung 21 einen weiteren, speziell zur Anziehung durch das Magnetfeld vorhandenen ringförmigen Körper 33. Der ringförmige Körper 33 liegt innerhalb des Rings der Magnete und ist als ein Permanentmagnet oder als ein nichtpermanentmagnetischer, ein magnetisch anziehbares, insbesondere paramagnetisches, Material aufweisender Körper ausgebildet, z.B. ein Eisen, Kobalt und/oder Nickel aufweisender Körper. Der Drehknebel 32 ermöglicht eine stärkere Abbremsung als der Drehknebel 16 und/oder eine geringere Beeinflussung der Wechselwirkung der Magnete 17 mit den Hallsensoren 18. Ein permanentmagnetischer Körper 33 ermöglicht eine stärkere Anziehung als ein nicht permanentmagnetischer Körper 33, während der nicht permanentmagnetische Körper 33 die Hallsensoren 18 weniger beeinflusst.

Selbstverständlich ist die vorliegende Erfindung nicht auf die gezeigten Ausführungsbeispiele beschränkt.

So mag der Drehknebel 16; 32 auch durch eine sich ändernde Stärke des Magnetfelds eines als Elektromagneten ausgestalteten Magneten 20 variiert werden.

### Bezugszeichenliste

- 11: Kochgerät
- 12: Kochplatte
- 13: Kochstelle
- 14: Bedienfeld
- 15: Positionierungsbereich
- 16: Drehknebel
- 17: Magnet
- 18: Hallsensor
- 19: Befestigungsmagnet
- 20: Magnet
- 21: Magnetfeldvorrichtung
- 22: Anzeigefeld
- 32: Drehknebel
- 33: ringförmiger, magnetisch anziehbarer Körper
- R: Rotationsachse

## Patentansprüche

1. Haushaltsgerät (11) mit einem Drehknebel (16, 32), das Haushaltsgerät aufweisend einen Positionierungsbereich (15) zur abnehmbaren Positionierung des Drehknebels (16; 32), welcher Drehknebel (16; 32) mindestens einen magnetisch anziehbaren Körper (17, 20; 33) aufweist, wobei das Haushaltsgerät (11) mindestens eine steuerbare Magnetfeldvorrichtung (21) zur Bereitstellung eines Magnetfelds am Ort zumindest eines Teils der gleichmäßig um die Rotationsachse (R) verteilten magnetisch anziehbaren Körper (17, 20; 33) des Drehknebels (11) aufweist,
- der mindestens eine magnetisch anziehbare Körper (17; 33) mehrere magnetisch anziehbare Körper (17; 33) aufweist, von denen mehrere Körper (17) gleichmäßig um seine Rotationsachse (R) verteilt sind,
- die mindestens eine steuerbare Magnetfeldvorrichtung (21) mindestens einen Elektromagneten zur Erzeugung des Magnetfelds aufweist,
wobei das Haushaltsgerät weiterhin dazu ausgebildet ist,
- die Magnetfeldvorrichtung (21) zur Änderung eines Drehwiderstands einer Drehbewegung des Drehknebels (16) zu steuern, und
- eine Stärke des Magnetfelds in Abhängigkeit von mindestens einem durch den Drehknebel (16; 32) einstellbaren Betriebsparameter einzustellen.

2. Haushaltsgerät (11) nach einem der vorhergehenden Ansprüche, **dadurch gekennzeichnet, dass** der Drehknebel (32) zusätzlich mindestens einen weiteren magnetisch anziehbaren Körper (33) aufweist, der dediziert zur Wechselwirkung mit der Magnetfeldvorrichtung (21) vorgesehen ist.

3. Haushaltsgerät (11) nach Anspruch 2, **dadurch gekennzeichnet, dass** der mindestens eine weitere magnetisch anziehbaren Körper (33) konzentrisch zu der Rotationsachse angeordnet ist.

4. Haushaltsgerät (11) nach Anspruch 3, **dadurch gekennzeichnet, dass** der mindestens eine weitere magnetisch anziehbare Körper (33) in einer bezüglich der Rotationsachse radialen Richtung zwischen einem mittigen Befestigungsmagneten (19) und den zur Feststellung einer Drehstellung und/oder Drehbewegung verwendeten mehreren magnetisch anziehbaren Körpern (17; 33) angeordnet ist.

5. Haushaltsgerät (11) nach einem der vorhergehenden Ansprüche, **dadurch gekennzeichnet, dass** die mindestens eine steuerbare Magnetfeldvorrichtung (21) dazu eingerichtet ist, ein zumindest im Wesentlichen gleichmäßig anziehendes Magnetfeld im Bereich einer Bahn zumindest eines Teils des mindestens einen magnetisch anziehbaren Körpers (17; 33) zu erzeugen.

6. Haushaltsgerät nach einem der vorhergehenden Ansprüche, **dadurch gekennzeichnet, dass** die mindestens eine steuerbare Magnetfeldvorrichtung (21) dazu eingerichtet ist, ein lokal anziehendes Magnetfeld im Bereich einer Bahn mindestens eines Teils des mindestens einen magnetisch anziehbaren Körpers (17) zu erzeugen, wobei lokal anziehende Bereiche einen Abstand aufweisen, welcher einem Abstand des mindestens einen magnetisch anziehbaren Körpers (17) entspricht.

7. Haushaltsgerät nach einem der vorhergehenden Ansprüche, **dadurch gekennzeichnet, dass** die mindestens eine steuerbare Magnetfeldvorrichtung (21) dazu eingerichtet ist, das Magnetfeld symmetrisch sektorförmig zu einer Rotationsachse (R) im Bereich zumindest eines Teils des mindestens einen magnetisch anziehbaren Körpers zu erzeugen.

8. Haushaltsgerät (11) nach einem der vorhergehenden Ansprüche, **dadurch gekennzeichnet, dass** die mindestens eine steuerbare Magnetfeldvorrichtung (21) dazu eingerichtet ist, das Magnetfeld vollständig umlaufend im Bereich der Bahn zumindest eines Teils des mindestens einen magnetisch anziehbaren Körpers (17; 33) zu erzeugen.

9. Haushaltsgerät (11) nach einem der vorhergehenden Ansprüche, **dadurch gekennzeichnet, dass** das Haushaltsgerät (11) ein Kochgerät mit einer oberseitigen Kochfeldplatte (12) ist und dass die mindestens eine steuerbare Magnetfeldvorrichtung (21) unterhalb der Kochfeldplatte (12) angeordnet ist.

10. Haushaltsgerät (11) nach einem der vorhergehenden Ansprüche, **dadurch gekennzeichnet, dass** der mindestens eine Betriebsparameter eine Kochstufe umfasst.

11. Haushaltsgerät (11) nach einem der vorhergehenden Ansprüche, **dadurch gekennzeichnet, dass** das Haushaltsgerät (11) dazu eingerichtet ist, die eine Stärke des Magnetfelds so einzustellen, dass mit einem Erreichen eines Endwerts eines aktuell einstellbaren Betriebsparameters ein Endanschlag für den Drehknebel (16) bereitgestellt wird.

12. Haushaltsgerät (11) nach einem der Ansprüche 1 bis 10, **dadurch gekennzeichnet, dass** das Haushaltsgerät (11) dazu eingerichtet ist, die eine Stärke des Magnetfelds so einzustellen, dass mit einer Näherung an einen Endwert eines aktuell einstellbaren Betriebsparameters eine steigende Stärke des Magnetfelds bereitgestellt wird.

13. Verfahren zum Betreiben eines Haushaltsgeräts (11) nach einem der vorhergehenden Ansprüche, welches zu seiner Bedienung mindestens einen abnehmbar befestigbaren Drehknebel (16; 32) mit mehreren magnetisch anziehbaren Körpern (17, 20; 33) aufweist, von denen mehrere Körper (17) gleichmäßig um seine Rotationsachse (R) verteilt sind, wobei das Verfahren mindestens den folgenden Schritt aufweist:
- Variieren eines Magnetfelds am Ort zumindest eines Teils der gleichmäßig um die Rotationsachse (R) verteilten magnetisch anziehbaren Körper (17; 33), um einen Drehwiderstand einer Drehbewegung des Drehknebels (16; 32) so zu ändern, dass eine Stärke des Magnetfelds in Abhängigkeit von mindestens einem durch den Drehknebel (16; 32) einstellbaren Betriebsparameter eingestellt wird.

## Claims

1. Household appliance (11) with a rotating knob (16, 32), the household appliance having a positioning region (15) for removably positioning the rotating knob (16; 32), which rotating knob (16; 32) has at least one magnetically attractable body (17, 20; 33), wherein the household appliance (11) has at least one controllable magnetic field device (21) for providing a magnetic field at the location of at least one part of the magnetically attractable body (17, 20; 33) of the rotating knob (11) which is distributed uniformly about the axis of rotation (R),
- the at least one magnetically attractable body (17; 33) has a number of magnetically attractable bodies (17; 33), of which a number of bodies (17) are distributed uniformly about its axis of rotation (R),
- the at least one controllable magnetic field device (21) has at least one electromagnet for generating the magnetic field, wherein the household appliance is also embodied
- to control the magnetic field device (21) in order to change a variable resistance of a rotating movement of the rotating knob (16), and
- to adjust a strength of the magnetic field as a function of at least one operating parameter that can be adjusted by the rotating knob (16; 32).

2. Household appliance (11) according to one of the preceding claims, **characterised in that** the rotating knob (32) additionally has at least one further magnetically attractable body (33), which is provided solely to interact with the magnetic field device (21).

3. Household appliance (11) according to claim 2, **characterised in that** the at least one further magnetically attractable body (33) is arranged concentrically with respect to the axis of rotation.

4. Household appliance (11) according to claim 3, **characterised in that** the at least one further magnetically attractable body (33) is arranged in a radial direction, with respect to the axis of rotation, between a central fastening magnet (19) and the number of magnetically attractable bodies (17, 33) used to fix a rotational position and/or rotational movement.

5. Household appliance (11) according to one of the preceding claims, **characterised in that** the at least one controllable magnetic field device (21) is designed to generate an at least substantially uniformly attracting magnetic field in the region of a path of at least one part of the at least one magnetically attractable body (17, 33).

6. Household appliance according to one of the preceding claims, **characterised in that** the at least one controllable magnetic field device (21) is designed to generate a locally attracting magnetic field in the region of a path of at least one part of the at least one magnetically attractable body (17), wherein locally attracting regions have a distance which corresponds to a distance of the at least one magnetically attractable body (17).

7. Household appliance according to one of the preceding claims, **characterised in that** the at least one controllable magnetic field device (21) is designed to generate the magnetic field symmetrically as a sector with respect to the axis of rotation (R) in the region of at least one part of the at least one magnetically attractable body.

8. Household appliance (11) according to one of the preceding claims, **characterised in that** the at least one controllable magnetic field device (21) is designed to generate the magnetic field completely circumferentially in the region of the path of at least one part of the at least one magnetically attractable body (17, 33).

9. Household appliance (11) according to one of the preceding claims, **characterised in that** the household appliance (11) is a cooking appliance with a cooking zone (12) on the top side, and that the at least one controllable magnetic field device (21) is arranged below the cooking zone (12).

10. Household appliance (11) according to one of the preceding claims, **characterised in that** the at least one operating parameter comprises a cooking level.

11. Household appliance (11) according to one of the preceding claims, **characterised in that** the household appliance (11) is designed to adjust a strength of the magnetic field so that an end stop for the rotating knob (16) is provided when an end value of a currently adjustable operating parameter is reached.

12. Household appliance (11) according to one of claims 1 to 10, **characterised in that** the household appliance (11) is designed to adjust a strength of the magnetic field so that an increasing strength of the magnetic field is provided when an end value of a currently adjustable operating parameter is approached.

13. Method for operating a household appliance (11) according to one of the preceding claims, which, for its operation, has at least one removably fastenable rotating knob (16; 32) with a number of magnetically attractable bodies (17, 20; 33), of which a number of bodies (17) are distributed uniformly about its axis of rotation (R), wherein the method has at least the following step:
- varying a magnetic field at the location of at least one part of the magnetically attractable body (17; 33) distributed uniformly about the axis of rotation (R), in order to change a variable resistance of a rotational movement of the rotating knob (16; 32) so that a strength of the magnetic field is adjusted as a function of at least one operating parameter which can be adjusted by the rotating knob (16; 32).

## Revendications

1. Appareil ménager (1) comprenant un bouton rotatif (16 ; 32), l'appareil ménager présentant une zone de positionnement (15) pour le positionnement amovible du bouton rotatif (16 ; 32), lequel bouton rotatif (16 ; 32) présente au moins un corps (17, 20 ; 33) magnétiquement attirable, l'appareil ménager (11) présentant au moins un dispositif à champ magnétique (21) commandable pour la fourniture d'un champ magnétique à l'endroit au moins d'une partie des corps (17, 20 ; 33) magnétiquement attirables, répartis régulièrement autour de l'axe de rotation (R), du bouton rotatif (11),
- l'au moins un corps (17 ; 33) magnétiquement attirable présentant plusieurs corps (17 ; 33) magnétiquement attirables dont plusieurs corps (17) sont répartis régulièrement autour de son axe de rotation (R),
- l'au moins un dispositif à champ magnétique (21) commandable présentant au moins un électroaimant pour générer le champ magnétique,
l'appareil ménager étant en outre réalisé
- pour commander le dispositif à champ magnétique (21) dans le but de modifier une résistance de rotation d'un mouvement de rotation du bouton rotatif (16), et
- pour régler une intensité du champ magnétique en fonction d'au moins un paramètre de fonctionnement réglable au moyen du bouton rotatif (16 ; 32).

2. Appareil ménager (11) selon l'une quelconque des revendications précédentes, **caractérisé en ce que** le bouton rotatif (32) présente en outre au moins un corps (33) magnétiquement attirable supplémentaire, lequel est ménagé de manière dédiée à l'interaction avec le dispositif à champ magnétique (21).

3. Appareil ménager (11) selon la revendication 2, **caractérisé en ce que** l'au moins un corps (33) magnétiquement attirable supplémentaire est disposé concentriquement par rapport à l'axe de rotation.

4. Appareil ménager (11) selon la revendication 3, **caractérisé en ce que** l'au moins un corps (33) magnétiquement attirable supplémentaire est disposé entre un aimant central de fixation (19) et les plusieurs corps (17 ; 33) magnétiquement attirables utilisés pour le blocage d'une position de rotation et/ou d'un mouvement de rotation dans une direction radiale par rapport à l'axe de rotation.

5. Appareil ménager (11) selon l'une quelconque des revendications précédentes, **caractérisé en ce que** l'au moins un dispositif à champ magnétique (21) commandable est configuré pour générer un champ magnétique attirant au moins essentiellement régulièrement dans la zone d'une voie au moins d'une partie de l'au moins un corps (17 ; 33) magnétiquement attirable.

6. Appareil ménager selon l'une quelconque des revendications précédentes, **caractérisé en ce que** l'au moins un dispositif à champ magnétique (21) commandable est configuré pour générer un champ magnétique attirant localement dans la zone d'une voie au moins d'une partie de l'au moins un corps (17) magnétiquement attirable, des zones attirant localement présentant un écart qui correspond à un écart de l'au moins un corps (17) magnétiquement attirable.

7. Appareil ménager selon l'une quelconque des revendications précédentes, **caractérisé en ce que** l'au moins un dispositif à champ magnétique (21) commandable est configuré pour générer le champ magnétique symétriquement en forme de secteurs par rapport à un axe de rotation (R) dans la zone au moins d'une partie de l'au moins un corps magnétiquement attirable.

8. Appareil ménager (11) selon l'une quelconque des revendications précédentes, **caractérisé en ce que** l'au moins un dispositif à champ magnétique (21) commandable est configuré pour générer le champ magnétique entièrement de manière périphérique dans la zone de la voie au moins d'une partie de l'au moins un corps (17 ; 33) magnétiquement attirable.

9. Appareil ménager (11) selon l'une quelconque des revendications précédentes, **caractérisé en ce que** l'appareil ménager (11) est un appareil de cuisson comprenant une plaque de champ de cuisson (12) sur le côté supérieur et **en ce que** l'au moins un dispositif à champ magnétique (21) commandable est disposé en dessous de la plaque de champ de cuisson (12).

10. Appareil ménager (11) selon l'une quelconque des revendications précédentes, **caractérisé en ce que** l'au moins un paramètre de fonctionnement comprend un étage de cuisson.

11. Appareil ménager (11) selon l'une quelconque des revendications précédentes, **caractérisé en ce que** l'appareil ménager (11) est configuré pour régler une intensité du champ magnétique de manière à ce que lorsqu'une valeur finale d'un paramètre de fonctionnement momentanément réglable est obtenue, une butée finale soit fournie pour le bouton rotatif (16).

12. Appareil ménager (11) selon l'une quelconque des revendications 1 à 10, **caractérisé en ce que** l'appareil ménager (11) est configuré pour régler une intensité du champ magnétique de manière à ce que lorsqu'une valeur finale d'un paramètre de fonctionnement momentanément réglable est approchée, une intensité croissante du champ magnétique soit fournie.

13. Procédé de fonctionnement d'un appareil ménager (11) selon l'une quelconque des revendications précédentes, lequel, pour sa commande, présente au moins un bouton rotatif (16 ; 32), pouvant être fixé de manière amovible, comprenant plusieurs corps (17, 20 ; 33) magnétiquement attirables dont plusieurs corps (17) sont répartis régulièrement autour de son axe de rotation (R), le procédé présentant au moins l'étape suivante :
- variation d'un champ magnétique à l'endroit au moins d'une partie des corps (17 ; 33) magnétiquement attirables, répartis régulièrement autour de l'axe de rotation (R), afin de modifier une résistance de rotation d'un mouvement de rotation du bouton rotatif (16 ; 32) de manière à ce qu'une intensité du champ magnétique soit réglée en fonction d'au moins un paramètre de fonctionnement réglable au moyen de l'au moins un bouton rotatif (16 ; 32).
